## Europäisches Patentamt

## European Patent Office

## Office européen des brevets

(11) Veröffentlichungsnummer: **0 097 845**
**B1**

(12) **EUROPÄISCHE PATENTSCHRIFT**

(45) Veröffentlichungstag der Patentschrift:
**07.01.87**

(21) Anmeldenummer: **83105551.2**

(22) Anmeldetag: **06.06.83**

(51) Int. Cl.⁴: **G 01 R 27/28**

(54) Verfahren und Anordnung zur Ermittlung der Dämpfungsverzerrung und der Gruppenlaufzeitverzerrung eines Messobjekts, insbesondere einer Datenübertragungsstrecke.

(30) Priorität: **28.06.82 DE 3224080**

(43) Veröffentlichungstag der Anmeldung:
**11.01.84 Patentblatt 84/2**

(45) Bekanntmachung des Hinweises auf die Patenterteilung:
**07.01.87 Patentblatt 87/2**

(84) Benannte Vertragsstaaten:
**BE DE FR GB IT**

(56) Entgegenhaltungen:
**DE - A - 2 849 119**
**DE - A - 3 048 831**
**US - A - 4 264 959**

**ntz NACHRICHTENTECHNISCHE ZEITSCHRIFT, Band 34 (1981), Heft 1 G. BLÄSZ "Messverfahren zur Bestimmung von Pegel und Gruppenlaufzeit", Seiten 20-24**

(73) Patentinhaber: **Siemens Aktiengesellschaft Berlin und München, Wittelsbacherplatz 2, D-8000 München 2 (DE)**

(72) Erfinder: **Bläss, Gerhard, Dipl.-Ing., Buchfinkenstrasse 11c, D-8037 Olching (DE)**

**Beschreibung**

Die Erfindung bezieht sich auf ein Verfahren und eine Anordnung zur Ermittlung der Dämpfungsverzerrung und der Gruppenlaufzeitverzerrung eines Messobjekts, insbesondere einer Datenübertragungsstrecke, bei dem dem Messobjekt ein Testpuls zugeführt und die durch das Messobjekt verursachte Verformung des Testpulses am Ausgang des Messobjekts (Pulsantwort) ausgewertet wird, wobei der Testpuls aus bezüglich ihrer Amplitude und Phase vorgegebenen, einander überlagerten Schwingungen unterschiedlicher Frequenz besteht, mit Hilfe der Fourier-Analyse die Pulsantwort zerlegt sowie die einzelnen Frequenzkomponenten hinsichtlich ihrer Amplituden und ihrer Phasenbeziehung zueinander bestimmt werden und durch Vergleich der Pulsantwort mit dem ursprünglich gesendeten Testpuls die Dämpfungs- und Gruppenlaufzeitverzerrung ermittelt wird.

Bei einem bekannten Verfahren dieser Art (G. Bläß: «Messverfahren zur Bestimmung von Pegel und Gruppenlaufzeit», ntz, Bd. 34 (1981) Heft 1, Seiten 20 bis 24; vgl. auch die US-A 4 264 959 bzw. die DE-A 2 724 991) wird eine Datenleitung als Messobjekt mit einem Testpuls beaufschlagt, der aus einer Anzahl von Cosinusschwingungen besteht, die beispielsweise über einen Frequenzbereich von 0,2 bis 3,6 kHz gleichmässig verteilt sind. Am Ausgang des Messobjekts wird der Testpuls mit seinen durch das Messobjekt bedingten Verformungen mit Hilfe der schnellen Fourier-Transformation analysiert und aufgrund der Betrags- und Phasenänderungen der einzelnen Cosinusschwingungen das Übertragungsverhalten der Datenleitung ermittelt. Das Übertragungsverhalten einer solchen Datenleitung kann aber auch durch einen Frequenzversatz der Schwingungen am Ausgang der Datenleitung gegenüber den Schwingungen am Eingang der Datenleitung, bedingt durch Frequenzumsetzer im Verlauf der Datenleitung, beeinflusst werden. Für die oben angeführte Auswertung ist dies zwar wenig störend, solange der Frequenzversatz unter einer vorgegebenen Toleranzgrenze liegt; für Anwendungsfälle besteht jedoch die Gefahr, dass eine vorgegebene Toleranzgrenze überschritten wird. Hier ist es notwendig, auch den Frequenzversatz und seinen Einfluss auf die Ermittlung der Dämpfungs- und Gruppenlaufzeitverzerrung zu berücksichtigen.

Weiterhin ist bekannt (E. O. Brigham: "The fast Fourier Transform", Prentice-Hall Inc., USA, 1974, Seiten 140 ff.), den Abtastwerten am Ausgang des Messobjekts, die zur Erfassung des Testpulses (Pulsantwort) am Ausgang des Messobjekts dienen, eine spezielle Fensterfunktion zu überlagern und somit den störenden Einfluss des Frequenzversatzes zu unterdrücken. Um eine hinreichend gute Kompensation des Frequenzversatzes zu erreichen, müssen jedoch bei diesem bekannten Verfahren mehrere Perioden des Testpulses am Ausgang des Messobjekts abgetastet und ausgewertet werden, was somit eine relativ grosse Mess- und Rechenzeit und zusätzliche Speichermedien zur Zwischenspeicherung der zusätzlichen Abtastwerte erforderlich macht.

Der Erfindung liegt die Aufgabe zugrunde, ein Verfahren und eine Anordnung zur Ermittlung der Dämpfungs- und der Gruppenlaufzeitverzerrung eines Messobjekts zu schaffen, bei dem der Einfluss eines durch das Messobjekt hervorgerufenen Frequenzversatzes weitgehend korrigiert wird.

Die Aufgabe wird bei einem Verfahren der eingangs angegebenen Art dadurch gelöst, dass zur Kompensation eines Frequenzversatzes durch das Messobjekt bei der Ermittlung der Dämpfungsverzerrung und der Gruppenlaufzeitverzerrung in einer ersten Messphase der Frequenzversatz zwischen den vorgegebenen Schwingungen des Testpulses und entsprechenden Schwingungen der Pulsantwort ermittelt wird, in einer zweiten Messphase die Amplitude und die Phase der vom Messobjekt unter anderem mit einem Frequenzversatz beeinflussten Schwingungen gemessen und in einer dritten Messphase die aufgrund der durch den Frequenzversatz entstandenen störenden Überlagerungen von Nebelwellenanteilen jeder harmonischen Schwingung auf benachbarte Schwingungen kompensiert werden.

Die Bestimmung des Frequenzversatzes lässt sich bei dem erfindungsgemässen Verfahren in an sich bekannter Weise, z.B. durch Messung des Frequenzunterschiedes von mindestens einer der Schwingungen am Ausgang des Messobjekts, von der entsprechenden bekannten, vorgegebenen Schwingung am Eingang des Messobjekts bzw. durch ein bekanntes Zweiton-Messverfahren durchführen. Dieser Frequenzunterschied stellt den durch das Messobjekt hervorgerufenen Frequenzversatz dar und wird in vorteilhafter Weise während der dritten Messphase zur Korrektur des durch diesen Frequenzversatz hervorgerufenen Einflusses auf den Betrag und die Phase der einzelnen Schwingungen herangezogen. Der störende Einfluss des Frequenzversatzes wird in erster Linie durch die Nebenwellen einer jeden harmonischen Schwingung verursacht, die durch eine aufgrund der Frequenzverschiebung hervorgerufene Sprungstelle an der Abtastperiodengrenze bei der Fourier-Analyse entstehen.

Eine Bestimmung des Frequenzversatzes bei der Ermittlung von Gruppenlaufzeit- und Dämpfungsverzerrungen ist beispielsweise aus der DE-A 3 048 831 bekannt. Auch hier wird das Messobjekt mit einem Mehrton-Verfahren untersucht. Die Auswertung erfolgt hier durch zeitliche Mitteilung einer Schar von mehreren Messungen, die nacheinander ausgewertet werden. Eine Kompensation des Frequenzversatzeinflusses auf andere Messergebnisse ist nicht angesprochen.

In besonders vorteilhafter Weise kann der Einfluss des Frequenzversatzes ermittelt werden, wenn in der zweiten Messphase die von der frequenzmässig jeweils benachbarten harmonischen Schwingung aufgrund des Frequenzversatzes hervorgerufenen störenden Nebenwellenanteile einer jeden harmonischen Schwingung aus der Grösse des Frequenzversatzes und dem Betrag und der Phase der Schwingung ermittelt werden und in der dritten Messphase der Einfluss eines jeden Nebenwellenanteils durch phasenrichtige Subtraktion des störenden Nebenwellenanteils an der jeweiligen harmonischen Schwingung eliminiert wird, wobei bei einer weiteren Ausgestaltung des Verfahrens auch die von frequenzmässig entfernt liegenden harmonischen Schwingungen hervorgerufenen Nebenwellenanteile ermittelt und eliminiert werden. Dies lässt sich auf einfache Weise durchführen, da die durch die Fourier-Analyse des Testpulses am Ausgang des Messobjekts sich ergebenden, einzelnen Frequenzen zugeordneten Linien in einem durch die Abtastperiode vorgegebenen Frequenzraster durch die harmonischen Schwingungen mitsamt den Nebenwellenanteilen gebildet sind; der Betrag einer jeden Linie ist hierbei aus einer phasengerechten Summation der Amplituden der Harmonischen und der durch den Frequenzversatz entstandenen Nebenwellenanteile der benachbarten harmonischen Schwingungen gebildet. Dieser Einfluss kann somit auf einfache Weise rechnerisch kompensiert werden.

Zur Durchführung des erfindungsgemässen Verfahrens weist eine Anordnung einen Messsender zur Erzeugung des Testpulses auf sowie einen Messbaustein zur Auswertung des Testpulses mit Hilfe der schnellen Fourier-Analyse am Ausgang des Messobjekts und einen Anzeigebaustein zur Anzeige von aus der schnellen Fourier-Analyse ermittelten Werten für die Dämpfungs- und Gruppenlaufzeitverzerrungen des Messobjekts. Bei dieser Anordnung ist in vorteilhafter Weise eine Kompensationsschaltung zur Kompensation eines im Messobjekt hervorgerufenen Frequenzversatzes vorhanden, bei der an einem Eingang ein dem gemessenen Frequenzversatz entsprechendes Signal anliegt, an einem anderen Eingang der vom Messbaustein ausgewertete Testpuls anliegt und mit der die Korrektur der durch den Frequenzversatz hervorgerufenen Überlagerungen der Anteile der Nebenwellen einer jeden Harmonischen durchgeführt wird. Mit Hilfe dieser Kompensationsschaltung werden das Ausgangssignal des Messbausteins zur Durchführung der Fourier-Analyse und der Frequenzversatz durch das Messobjekt zur Durchführung des erfindungsgemässen Verfahrens ausgewertet. Die Kompensationsschaltung kann beispielsweise einen Mikrocomputer enthalten, der aufgrund eines eingegebenen Rechenprogramms den Einfluss der durch den Frequenzversatz verursachten Nebenwellenanteile am Ausgang des Messobjekts ermittelt. Der durch den Frequenzversatz hervorgerufene Einfluss kann somit rechnerisch kompensiert werden. Die am Anzeigebaustein angezeigten, aus dem Ausgangssignal des Messobjekts ermittelten Werte sind somit vom fehlerhaften Einfluss des Frequenzversatzes bereinigt, so dass eine ausserordentlich genaue Messung der Dämpfungs- und der Gruppenlaufzeitverzerrung des Messobjekts möglich ist.

Die Erfindung wird anhand der Figuren erläutert, wobei

Fig. 1 ein Blockschaltbild einer Anordnung zur Durchführung des erfindungsgemässen Verfahrens,

Fig. 2 ein Beispiel eines Linienspektrums des Testpulses am Eingang und am Ausgang des Messobjekts,

Fig. 3 eine einzelne vorgegebene harmonische Schwingung des Testpulses mit vom Frequenzversatz verursachten Nebenwellenanteilen und

Fig. 4 die Überlagerung der verschiedenen Einflüsse auf eine Linie des Linienspektrums unter Berücksichtigung von Betrag und Phase darstellen.

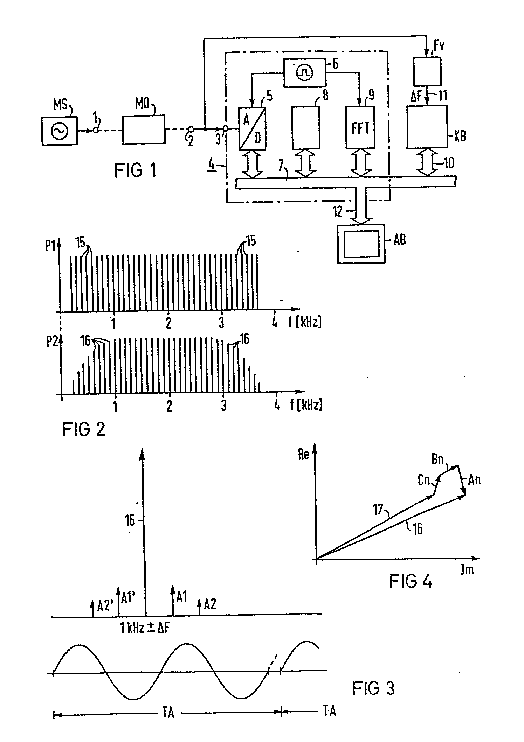

In der Figur 1 ist ein Messsender MS dargestellt, der an einem Eingang 1 eines Messobjekts MO, hier eine Datenleitung, angeschlossen ist. Der Ausgang 2 des Messobjekts MO ist mit einem Eingang 3 eines Messbausteins 4 verbunden. Der Messbaustein 4 enthält einen Analog-Digital-Wandler 5, der, gesteuert von einem Taktgenerator 6, diskrete Abtastwerte des Testpulses am Ausgang des Messobjekts MO einer Busleitung 7 des Messbausteins 4 zur Verfügung stellt. Die Abtastwerte werden in einem Zwischenspeicher 8 gespeichert und sodann in einem Analysebaustein 9 mit der schnellen Fourier-Transformation (Fast Fourier Transform = FFT) ausgewertet. Der Analysebaustein 9 wird hier vom gleichen Takt des Taktgenerators 6 wie der Analog-Digital-Wandler 5 angesteuert und ist über die Busleitung 7 mit einem Kompensationsbaustein KB verbunden, der den Einfluss des durch einen Frequenzversatz im Bereich des Messobjekts hervorgerufenen Fehlers am Ausgangssignal des Analysebausteins 9 kompensiert, wobei über die Busleitung 10 die Daten, die sich als Ergebnis der schnellen Fourier-Transformation ergeben, übermittelt werden. Über eine Leitung 11 wird dem Kompensationsbaustein KB eine weitere Grösse zugeführt, die dem Frequenzversatz ΔF entspricht und in dem Baustein Fv am Ausgang des Messobjekts MO oder auf andere Weise ermittelt wurde. Das Ausgangssignal des Analysebausteins 9, das die Information unter anderem über die Dämpfungs- und Gruppenlaufzeitverzerrung nach der Korrektur enthält, wird über die Busleitung 7 und eine Ausgangsleitung 12 einem Anzeigebaustein AB zugeführt. Die Ermittlung der die Dämpfung und Gruppenlaufzeit betreffenden Informationen ist in der bereits eingangs erwähnten Literaturstelle [G. Bläß: «Messverfahren zur Bestimmung von Pegel und Gruppenlaufzeit», ntz, Bd. 34 (1981) Heft 1, Seiten 20 bis 24] ausführlich beschrieben.

In der Figur 2 sind die Linienspektren P1 des Testpulses am Eingang des Messobjekts MO und die Linienspektren P2 am Ausgang des Messobjekts MO (Pulsantwort) dargestellt. Die Linien 15 kennzeichnen die einzeln vorgegebenen Schwingungen am Eingang des Messobjekts, die bei diesem Ausführungsbeispiel allesamt Harmonische der Grundwelle 100 Hz sind und sich über den Bereich von 200 Hz bis 3,6 Hz erstrecken. Alle vorgegebenen Schwingungen 15 weisen hier am Eingang des Messobjekts MO einen gleichen Normpegel auf. Die Linien 16 des Linienspektrums P2, die am Ausgang 2 des Messobjekts MO auftreten, weisen besonders im unteren und im oberen Frequenzbereich Veränderungen auf, die beispielsweise durch eine frequenzabhängige Dämpfung des Messobjekts MO hervorgerufen werden.

In der Figur 3 ist eine einzelne der vorgegebenen Schwingungen dargestellt, die hier im oberen Teil – im Frequenzbereich dargestellt – einer der Linien 16, z.B. bei 1 kHz $\pm\Delta F$, entspricht. Durch den Frequenzversatz des Messobjekts fällt nicht ein ganzzahliges Vielfaches der Periodendauer der Schwingung in eine Abtastperiode, so dass bei der Fourier-Analyse Nebenlinien A1, A2 usw. (hier nicht dargestellt) bzw. A1', A2' usw. (hier nicht dargestellt) entstehen. Im unteren Teil der Figur 3 ist diese, der Linie 16 bei 1 kHz entsprechende harmonische Schwingung im Zeitbereich unter anderem während der vorgegebenen Abtastperiode TA dargestellt, wobei sich durch den Frequenzversatz $\Delta F$ eine Sprungstelle am Ende der Abtastperiode TA ergibt, die zur Bildung der genannten Nebenlinien führt.

Da jede der harmonischen Schwingungen des Testpulses durch den Frequenzversatz ein solches Nebenwellenspektrum erzeugt, ergibt sich jede Linie im Frequenzbereich gemäss der Darstellung in der Figur 2 unten als eine Überlagerung sämtlicher Anteile, d.h. der harmonischen Schwingung und der Nebenwellenantriebe (Nebenlinien) der anderen Harmonischen bei der jeweiligen Frequenz. Die zuvor ermittelte Frequenzverschiebung (Frequenzversatz $\Delta F$) wird in den weiteren Messphasen des erfindungsgemässen Verfahrens im Kompensationsbaustein KB gemäss Figur 1 dazu benutzt, die Beträge unter Berücksichtigung der Phasen der Nebenwellenanteile jeder einzelnen vorgegebenen Schwingung bei ihrer Überlagerung innerhalb der einzelnen Linien des Linienspektrums zu ermitteln und anschliessend zu korrigieren. Es kann somit die durch den Frequenzversatz bedingte Überlagerung von Nebenwellenanteilen bei jeder einzelnen Linie subtrahiert werden.

Die Darstellung einer Linie 16 in der komplexen Ebene nach Figur 4 zeigt, dass bei einer Berücksichtigung auch der Phasenlage der einzelnen Nebenwellenanteile auch eine Kompensation der Phasenverzerrung, bedingt durch den Frequenzvorsatz, vorgenommen werden kann, so dass sich nach Kompensation aller Einflüsse nach Betrag und Phase eine Linie 17 ergeben würde. Die Überlagerungen An, Bn, Cn sind hier die Nebenwellen der anderen Harmonischen des Testpulses bei der hier dargestellten harmonischen Schwingung. Da somit die durch einen Frequenzversatz hervorgerufenen Verzerrungen des Betrags und der Phase einer jeden einzelnen Schwingung des Testpulses ermittelt und kompensiert werden können, ist hieraus eine Ermittlung der Dämpfungs- und Gruppenlaufzeitverzerrung des Messobjekts unter weitgehender Beseitigung des Einflusses eines Frequenzversatzes möglich.

**Patentansprüche**

1. Verfahren zur Ermittlung der Dämpfungsverzerrung und der Gruppenlaufzeitverzerrung eines Messobjekts (MO), insbesondere einer Datenübertragungsstrecke, bei dem
   - dem Messobjekt (MO) ein Testimpuls zugeführt und die durch das Messobjekt (MO) verursachte Verformung des Testpulses am Ausgang (2) des Messobjekts (MO) (Pulsantwort) ausgewertet wird, wobei
   - der Testpuls aus bezüglich ihrer Amplitude und Phase vorgegebenen, einander überlagerten harmonischen Schwingungen (15) unterschiedlicher Frequenz besteht,
   - mit Hilfe der Fourier-Analyse die Pulsantwort zerlegt sowie die einzelnen Frequenzkomponenten hinsichtlich ihrer Amplituden und ihrer Phasenbeziehung zueinander bestimmt werden und
   - durch Vergleich der Pulsantwort mit dem ursprünglich gesendeten Testpuls die Dämpfungs- und Gruppenlaufzeitverzerrung ermittelt wird, dadurch gekennzeichnet, dass zur Kompensation eines Frequenzversatzes durch das Messobjekt (MO) bei der Ermittlung der Dämpfungsverzerrung und der Gruppenlaufzeitverzerrung
   - in einer ersten Messphase der Frequenzversatz ($\Delta F$) zwischen den vorgegebenen Schwingungen (15) des Testpulses und entsprechenden Schwingungen (16) der Pulsantwort ermittelt wird,
   - in einer zweiten Messphase die Amplitude und die Phase der vom Messobjekt (MO) unter anderem mit einem Frequenzversatz beeinflussten Schwingungen (16) gemessen und
   - in einer dritten Messphase die aufgrund der durch den Frequenzversatz ($\Delta F$) entstandenen störenden Überlagerungen von Nebenwellenanteilen (A1, A2, A1', A2') jeder harmonischen Schwingung (16) auf benachbarte Schwingungen (16) kompensiert werden (Figur 1).

2. Verfahren nach Anspruch 1, dadurch gekennzeichnet, dass
   - in der zweiten Messphase die von der frequenzmässig jeweils benachbarten harmonischen Schwingung (16) aufgrund des Frequenzversatzes ($\Delta F$) hervorgerufenen störenden Nebenwellenanteile (z.B. A1, A1') einer jeden harmonischen Schwingung (16) aus der Grösse des Frequenzversatzes ($\Delta F$) und dem Betrag und der Phase der Schwingung ermittelt werden und dass
   - in der dritten Messphase der Einfluss eines jeden Nebenwellenanteils durch phasenrichtige Subtraktion des störenden Nebenwellenanteils von der jeweiligen harmonischen Schwingung (16) eliminiert wird.

3. Verfahren nach Anspruch 2, dadurch gekennzeichnet, dass
   - auch die von frequenzmässig entfernt liegenden harmonischen Schwingungen (16) hervorgerufenen Nebenwellenanteile (A1, A2, A1', A2') ermittelt und eliminiert werden.

4. Anordnung zur Durchführung des Verfahrens nach einem der vorhergehenden Ansprüche mit

– einem Messsender (MS) zur Erzeugung des Testpulses,

– einem Messbaustein (4) zur Auswertung des Testpulses mit Hilfe der schnellen Fourier-Analyse am Ausgang (2) des Messobjekts (MO) und

– einem Anzeigebaustein (AB) zur Anzeige von aus der schnellen Fourier-Analyse ermittelten Werten für die Dämpfungs- und Gruppenlaufzeitverzerrungen des Messobjekts (MO), dadurch gekennzeichnet, dass

– eine Kompensationsschaltung (KB) zur Kompensation eines im Messobjekt (MO) hervorgerufenen Frequenzversatzes vorhanden ist, bei der

– an einem Eingang ein dem gemessenen Frequenzversatz (ΔF) entsprechendes Signal anliegt,

– an einem anderen Eingang der vom Messbaustein (4) ausgewertete Testpuls anliegt und mit der

– die Korrektur der durch den Frequenzversatz (ΔF) hervorgerufenen Überlagerungen der Anteile der Nebenwellen einer jeden Harmonischen durchgeführt wird.

## Claims

1. A process for determining attenuation distortion and group transit time of a measured object (MO), in particular a data transmission, wherein:

– a test pulse is fed to the measured object (MO) and the distortion of the test pulse caused by the measured object (MO) is analysed at the output (2) of the measurd object (MO) (pulse reply), whereby

– the test pulse consists of mutually superimposed, harmonic oscillations (15) of different frequency predetermined in respect of their amplitude and phase;

– the pulse reply is examined with the aid of Fourier analysis and individual frequency components determined in respect of their amplitudes and their phase relationship to one another; and

– the attention distortion and group transit time is determined by comparison of the pulse reply with the originally transmitted test pulse; characterised in that in order to compensate for frequency displacement by the measured object (MO) when determining the attenuation distortion and the group transit time:

– in a first measuring phase the frequency displacement (ΔF) between the predetermined oscillations (15) of the test pulse and corresponding oscillations (15) of the pulse reply is determined;

– in a second measuring phase the amplitude and phase of the oscillations (16) influenced by the measured object (MO) among others by frequency displacement are measured; and

– in a third measuring phase the interfering superimpositions of spurious wave components (A1, A2, A1', A2') caused by the frequency displacement (ΔF) of each harmonic oscillation (16) on adjacent oscillations (16) are compensated (Figure 1).

2. A process as claimed in Claim 1, characterised in that:

– in the second measuring phase the interfering spurious wave components (e.g. A1, A1') of each harmonic oscillation (16), caused by the respectively adjacent harmonic oscillations (16) as a result of the frequency displacement (ΔF), are determined from the magnitude of the frequency displacement (ΔF) and the value and the phase of the oscillation; and that

– in the third measuring phase the influence of each spurious wave component is eliminated by the in-phase subtraction of the interfering spurious wave component from the respective harmonic oscillation (16).

A process as claimed in Claim 7, characterised in that:

– the spurious wave components (A1, A2, A1', A2') caused by harmonic oscillations (16) which are widely different in frequency are determined and eliminated.

4. An arrangement for carrying out the process as claimed in one of the preceding Claims, comprising:

– a measuring transmitter (MS) for producing the test pulses;

– a measuring module (4) for analysing the test pulses by rapid Fourier analysis at the output (2) of the measured object (MO); and characterised in that:

– a compensation circuit (KB) is provided for compensating frequency displacement caused in the measured object (MO), wherein:

– a signal corresponding to the measured frequency displacement (ΔF) is connected to an input;

– the test pulse analysed by the measuring module (4) is connected to another input; and by these means

– the correction of the frequency displacement (ΔF), of the spurious wave components of each harmonic is carried out.

## Revendications

1. Procédé pour déterminer la distorsion d'affaiblissement et la distorsion du temps de propagation de groupe fournies par un objet de mesure (MO), notamment une voie de transmission de données, selon lequel:

– on envoie une impulsion de côntrole à l'objet de mesure (MO) et en évalue la déformation de l'impulsion de contrôle, provoquée par l'objet de mesure (MO), au niveau de la sortie (2) de l'objet de mesure (MO) (réponse impulsionnelle),

– l'impulsion de contrôle étant constituée par des oscillations harmoniques (15) superposées les unes aux autres, prédéterminées du point de vue de leur amplitude et de leur phase et possédant des fréquences différentes,

– on décompose la réponse impulsionnelle à l'aide de l'analyse de Fourier et on détermine les composantes individuelles de fréquences du point de vue de leurs amplitudes et de leur relation de phase réciproque, et

– on détermine la distorsion d'affaiblissement et la distorsion du temps de propagation de groupe par comparaison de la réponse impulsionnelle avec l'impulsion de contrôle émise à l'origine, caractérisé en ce que pour réaliser la compensation d'un décalage de fréquence produit par l'objet de mesure (MO) lors de la détermination de la distorsion d'affaiblissement et de la distorsion de temps de propagation de groupe,

– au cours d'une première phase de mesure, on détermine le décalage de fréquence (ΔF) entre les oscillations prédéterminées (15) de l'impulsion de contrôle et des oscillations correspondantes (16) de la réponse impulsionnelle,

– au cours d'une seconde phase de mesure, on mesure l'amplitude et la phase des oscillations (16) influencées notamment avec un décalage de fréquence, par l'objet de mesure (MO), et

– au cours d'une troisième phase de mesure, on compense les superpositions parasites de composantes d'ondes secondaires (A1, A2, A1', A2') de chaque oscillation harmonique (16), qui apparaissent par suite du décalage de fréquence (ΔF) et qui sont appliquées aux oscillations voisines (16) (figure 1).

2. Procédé suivant la revendication 1, caractérisé par le fait que:

– pendant la seconde phase de mesure, on détermine les composantes parasites d'ondes secondaires (par exemple A1, A1') de chaque oscillation harmonique (16), qui sont provoquées par l'oscillation harmonique (16), respectivement voisines du point de vue de la fréquence, sur la base du décalage de fréquence (ΔF), à partir de la grandeur du décalage de fréquence (ΔF) et de la valeur et de la phase de l'oscillation, et que

– pendant la troisième phase de mesure, on supprime l'influence de chaque composante d'onde secondaire, par soustraction, correcte du point de vue de la phase, de la composante d'onde secondaire parasite, de l'oscillation harmonique respective (16).

3. Procédé suivant la revendication 2, caractérisé par le fait que:

– on détermine et on supprime également les composantes d'ondes secondaires (A1, A2, A1', A2') provoquées par des oscillations harmoniques (16) possédant des fréquences éloignées.

4. Dispositif pour la mise en œuvre du procédé suivant l'une des revendications précédentes, comportant

– un émetteur de mesure (MS) servant à produire l'impulsion de contrôle,

– un module de mesure (4) servant à évaluer l'impulsion de contrôle à l'aide de l'analyse de Fourier rapide, au niveau de la sortie (2) de l'objet de mesure (MO), et

– un module d'affichage (AB) servant à afficher des valeurs, déterminées à partir de l'analyse de Fourier rapide, pour les distorsions d'affaiblissement et les distorsions de temps de propagation de groupe de l'objet de mesure (MO), caractérisé par le fait

– qu'il est prévu un circuit de compensation (KB) qui sert à compenser un décalage de fréquence produit dans l'objet de mesure (MO) et dans lequel

– un signal correspondant au décalage de mesure (ΔF) mesuré est appliqué à une entrée,

– l'impulsion de contrôle évaluée par le module (4) est appliquée à une autre entrée et,

– à l'aide duquel on réalise la correction des superpositions, provoquées par le décalage de fréquence (ΔF), des composantes des ondes secondaires de chaque harmonique.

FIG 1

FIG 2

FIG 3

FIG 4